Europäisches Patentamt

European Patent Office

Office européen des brevets

(19)

(11) **EP 1 432 121 A1**

(12) **EUROPEAN PATENT APPLICATION**

(43) Date of publication:
**23.06.2004 Bulletin 2004/26**

(51) Int Cl.⁷: **H03F 1/30**, H03G 1/00,
H01C 13/00

(21) Application number: **02028195.2**

(22) Date of filing: **19.12.2002**

| | |
|---|---|
| (84) Designated Contracting States:<br>**AT BE BG CH CY CZ DE DK EE ES FI FR GB GR**<br>**IE IT LI LU MC NL PT SE SI SK TR**<br>Designated Extension States:<br>**AL LT LV MK RO**<br><br>(71) Applicant: **Digital Multimedia Technologies**<br>**20035 Lissone (MI) (IT)** | (72) Inventor: **Carcano, Marco**<br>**20030 Senago (MI) (IT)**<br><br>(74) Representative: **Grünecker, Kinkeldey,**<br>**Stockmair & Schwanhäusser Anwaltssozietät**<br>**Maximilianstrasse 58**<br>**80538 München (DE)** |

(54) **Temperature compensated amplifer circuit**

(57)    An amplifying chain (13) comprises a plurality of serially coupled amplifier stages (102, 105, 108)

Thus, the amplifying stages have an uncompensated gain which decreases with increasing temperature. To compensate the signal gain variation, attenuating stages are inserted into the amplifying chain with said attenuating stages being connected upstream with respect to the amplifying stages. The attenuating stages perform signal attenuation which varies as a function of the temperature so as to compensate the signal gain variation of the amplifying stages. The temperature depending attenuating devices comprise temperature depending resistive elements. In particular, resistive elements having a negatively temperature to coefficient.

FIG. 6

**Description**

FIELD OF THE PRESENT INVENTION

The present invention relates generally to RF (radio frequency) transmission.
More particularly, the present invention relates to amplifying circuits and/or devices of the kind used in RF transmission. In more detail, the present invention relates to temperature compensated amplifying circuits and/or devices of the kind used for RF transmission.

DESCRIPTION OF THE PRIOR ART

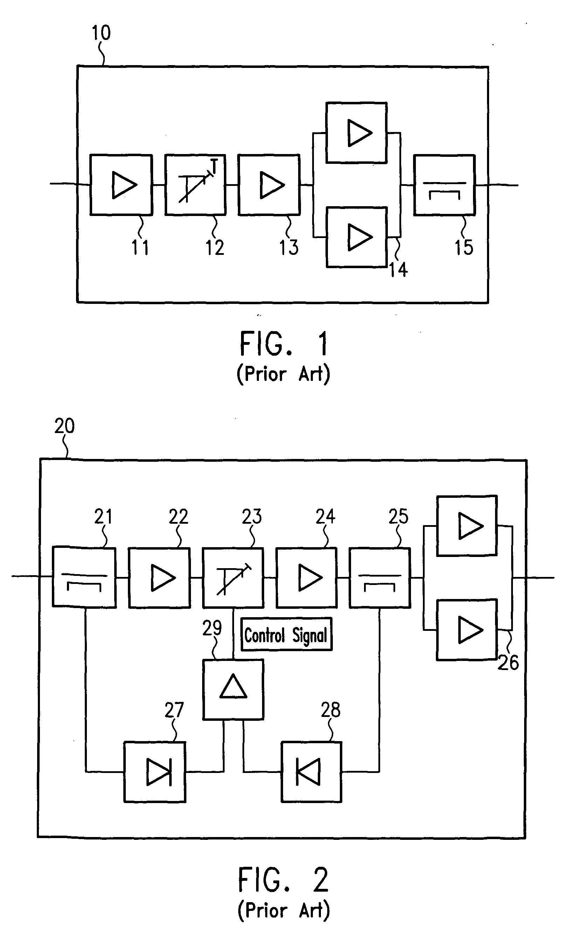

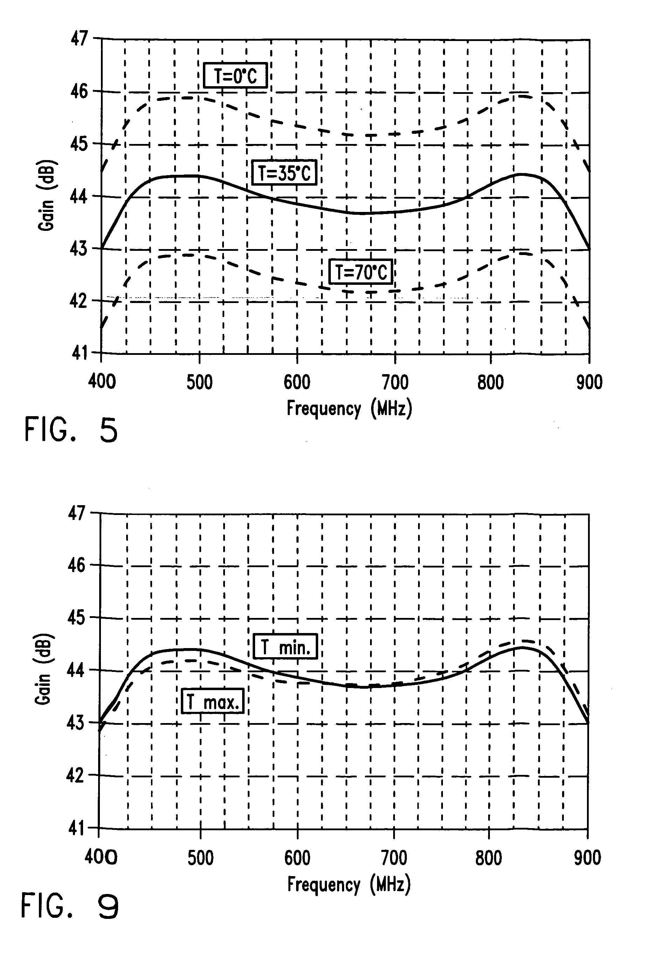

Amplifying circuits, for example comprising serially coupled amplifying stages are used in a wide variety of applications. For example, modern wireless communication products such as cellular telephones, satellite receivers and pagers require amplifiers to boost very weak signals that enter from the antenna to levels usable in subsequent receiver processing circuits. Amplifiers are used in transmitters as well, raising the power level emanating from signal modulation circuits to the level suitable for long range transmission. A common problem of setting the known amplifying circuits is that the signal gain i.e. the ratio between the output signal level (the signal level exiting the amplifying circuit) and the input signal level (the signal level entering the amplifying circuit) changes as a function of the temperature. In particular, it has been observed that the signal gain of the amplifying circuit decreases as the temperature of the circuit increases, due to e.g. both increasing ambient temperature and/or self heating of the active components of the circuit, arising from the workload and/or the power consumption of said components.
A typical behavior of a conventional amplifying circuit is depicted in Figure 5; in particular, in Figure 5, there is depicted the signal gain variation of a typical amplifying circuit as a function of both the frequency of the signal and the temperature of the circuit. As apparent from Figure 5, when the temperature changes, the gain response is shifted up and down on the graph; in particular, the graph of Figure 5 shows that, at a given frequency, a temperature variation from 0°C to 70°C produces a signal gain variation of 3dB, that is, $\Delta G/\Delta T=0,43dB/10°C$, where $\Delta G$ is the signal gain variation and $\Delta T$ is the temperature variation.
To overcome this drawback, several attempts have been made and several solutions have been proposed and developed in the art. Some of these solutions will be described in the following with reference to Figures 1 to 4.
In Figure 1 there is depicted a typical amplifying circuit in which a monolithic attenuator is used for the purpose of compensating the signal gain variation arising when the temperature of the circuit changes. In particular, in Figure 1, references 11, 13 and 14 relate to an input amplifier stage, a driver amplifier stage and a final power amplifier stage, respectively. Moreover, in Figure 1, reference 12 relates to a temperature compensated monolithic attenuator; finally, in Figure 1, reference 15 relates to an output directional coupler (output power monitoring).
In the amplifying circuit of Figure 1, the total gain of the amplifying stages 11, 13 and 14 naturally decreases when the temperature raises, that is, the signal gain has a negative gradient $\Delta G/\Delta T$. The attenuator 12 allows to partially compensate this behavior. In fact, the signal is attenuated at the stage 12, resulting in a weaker signal entering the amplifying stages 13 and 14. In particular, at a given temperature (depending on the temperature coefficient of the monolithic attenuator), the attenuation performed will approximately inversely correspond to the signal gain variation arising at said given temperature; accordingly, at said given temperature, the signal gain variation can be substantially compensated. However, the monolithic attenuator 12 of Figure 1 has a predefined temperature coefficient, or, in other words, the attenuator 12 has a predefined attenuation variation versus temperature $\Delta A/\Delta T$. Accordingly, it is not possible to use only one type of monolithic attenautor for different applications, with different values of $\Delta G/\Delta T$. On the contrary, it is likely to need a large number of different types of monolithic attenuators, with a corresponding negative impact on the costs and the managing. Moreover, the amplifying circuit of Figure 1 has the drawbacks that the monolithic attenuator 12 must be inserted downstream with respect to a first amplifying stage for the purpose of not negatively affecting the noise figure of the amplifier. Furthermore, the typical level of the input signal may not be more 20dBm for avoiding self-heating of the circuit.
A further prior art amplifying circuit will now be described with reference to Figure 2; in particular, in Figure 2 there is depicted the line up of a conventional analog AGC-compensated amplifying circuit.
In Figure 2, reference 20 relates to a amplifying circuit. Said amplifying circuit comprises an input amplifier stage 22, a driver amplifier stage 24 and a final amplifier stage 26. Moreover, the amplifying circuit 20 comprises an input directional coupler 21 and a directional coupler 25. This directional coupler 25 provides a feedback for an AGC (automatic gain control) loop as it will become apparent in the following. An attenuator 23 is provided between the input amplifier stage 22 and the driver amplifier stage 24. The attenuator 23 can be either a voltage operated attenuator or a current operated attenuator. In Figure 2, references 27 and 28 relate to an input power detector and a driver power detector, respectively. Finally, reference 29 relates to an error amplifier, for example a low frequency video amplifier.
The aim of the circuit of Figure 2 is to keep stable the amplifier gain by comparing a properly coupled sample of the output signal to a sample of the input signal. In particular, in the circuit of Figure 2, a sample of the input signal is fed to the input detector 27, while the properly coupled sample of the output signal is fed to the output detector 28. The two low frequency signals generated by the detectors 27 and 28 are then fed to the error amplifier 29, which in turn generates an output signal (error signal) proportional to the difference between the input signals. The error signal is the used to drive the attenuator 23. In particular, when a signal gain lower than expected and/or desired is detected, the signal sent by the error amplifier 29 drives the attenuator 23 so as to decrease the attenuation performed by the attenuator 23. In this way, a less attenuated signal enters the amplifier 24 and the signal gain diminution is compensated or, in other words, approximately the same signal as in normal conditions is output by the amplifier 24. On the contrary, when a signal gain higher than expected is detected, for instance, due to a lower temperature, the signal sent by the error amplifier 29 drives the attenuator 23 so as to increase the attenuation performed by the attenuator 23. In this way, a more attenuated signal than in a normal condition enters the amplifier 24 and substantially the same signal as in a normal condition is output by the amplifier 24. In other words, the signal gain variation (in this case diminution) is partially compensated by driving the attenuation of the attenuator 23.

The amplifying circuit of Figure 2 is affected by many drawbacks. For instance, the amplifying circuit 20 allows to detect signal gain variation between the amplifying stages 22 and 25 only, whilst the final stage 26 is normally kept out of the AGC loop otherwise the signal level at the input of the final stage could not be kept stable.

Another drawback affecting the amplifying circuit 20 is that the input signal may not normally be higher than 10dBm,otherwise the signal through the amplifying chain could be distorted.

A further drawback is that the amplifying circuit 20, in particular the feedback loop formed by the input power detector 27, the driver power detector 28 and the error amplifier 29, needs to be calibrated when implemented for analog applications in which the components are adapted to process analog signals.

Finally, the compensated attenuator 23 must be inserted downstream with respect to the first amplifying stage 22 for avoiding the noise figure of the circuit 20 to be negatively affected.

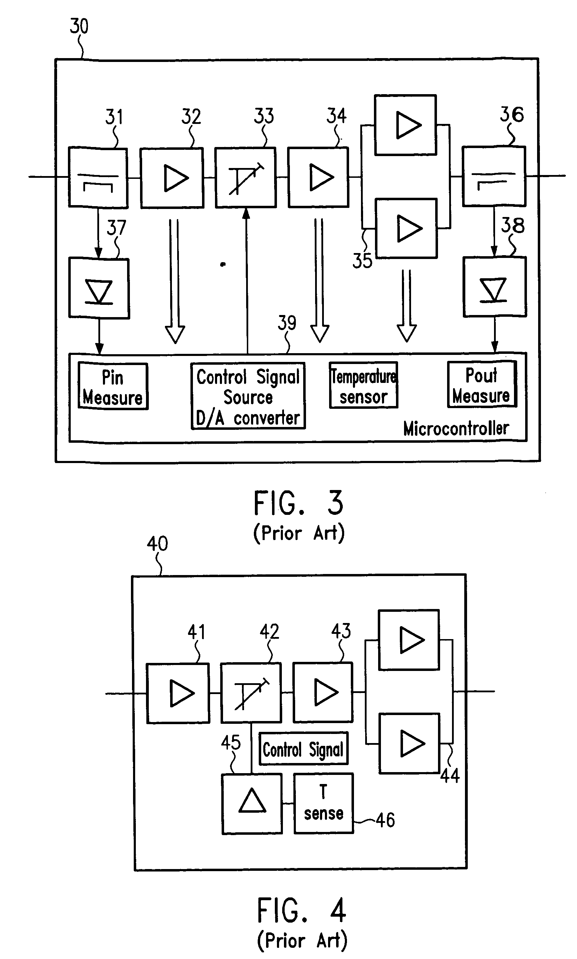

In Figure 3, there is depicted a further typical prior art temperature compensated amplifying circuit, i.e., a circuit comprising means for compensating the temperature related signal gain variation of the amplifying stages of the circuit. In particular, the circuit of Figure 3 represents the digital version of the AGC loop of Figure 2.

The amplifying circuit 30 of Figure 3 comprises three amplifying stages, namely an input amplifier stage 32, a driver amplifier stage 34 and a final amplifying stage 35. Moreover, in Figure 3, references 31 and 36 relate to an input directional coupler and an output directional coupler (AGC loop feedback). The circuit 30 further comprises an attenuator 33 which can be either a voltage operated attenuator or a current operated attenuator. An input power detector 37 and an output power detector 38 are connected to the input directional coupler 31 and the output directional coupler 36, respectively. The detectors 37 and 38 detect the signal at the stages 31 and 36 by measuring either the voltage or the current at these stages. The signals as collected are sent to a micro controller comprising devices for measuring the input signal detected by the detector 37 and the output signal detected by the detector 38, together with a temperature sensor for measuring the instant temperature of the circuit 30. The signal values at the amplifying stages 32, 34 and 35 are also sent to the microcontroller and processed together with the input signal, the output signal and the temperature values. Once the several signals collected have been processed and analyzed by the microcontroller 39, a signal depending on the analysis as executed is output from the microcontroller 39 and sent to the controlled attenuator 33; the signal output by the micro controller 39 can be either a current signal or a voltage signal. In this way, the attenuating function of the attenuator 33 is driven by the signal output by the micro controller 39, in the same way as in the case of the circuit 20 described with reference to Figure 2.

The amplifying circuit of Figure 30 offers the advantage with respect to the amplifying circuit 20 of Figure 2 that it is possible to place the second coupler 38 at the output of the final stage 36, since the micro-controller can take under control the status of the final stage and avoid stresses to the semiconductor devices used. However, the increased complexity of the circuit renders its implementation in many usual applications difficult and expensive. Moreover, other disadvantages affecting the circuit 20 also arise in the amplifying circuit 30 of Figure 3.

The amplifying circuit 40 of Figure 4 represents a further solution which has been proposed in the art for compensating the signal gain variation arising as a function of the temperature. In Figure 4, references 41, 43 and 44 relate to an input amplifier stage 43, a driver amplifier stage and a final amplifier stage, respectively. A controlled attenuator 42 is inserted between the input amplifier stage and the driver amplifier stage; said attenuator 42 can be either voltage operated or current operated. A control signal generation circuit 45 is connected to the control attenuator 42 and a temperature sensor 46 is connected to the circuit 45. In the amplifying circuit 40 of Figure 4, the temperature detected by the temperature sensor 46 is sent to the control signal generation circuit 45; depending on the temperature detected, a signal is generated on the basis of a predefined compensation table, correlating the control signal level to the measure of temperature. The signal as generated allows to control the attenuating function of the attenuator 42. However, in the amplifying circuit of Figure 4 the attenuation at the attenuating stage 42 is not directly related with the signal gain effectively performed by the circuit. On the contrary, the attenuator 42 is driven as a function of the temperature only. That means, if the behavior of the signal gain as a function of the temperature deviates from the behavior presumed, i.e., the signal gain behavior deviates from the predefined temperature - attenuation correspondence tables used for designing the circuit, the signal gain variation cannot be adequately compensated. In other words, the precision of operation is related to the accuracy of the compensation tables.

Accordingly, in view of the problems explained above, it would be desirable to provide a technique that may solve or reduce one of the problems identified above. In particular, it would be desirable to provide an amplifying circuit allowing a reliable compensation of the signal gain variation over a wide temperature range. In other words, it would be desirable to provide an amplifying circuit wherein the amplified signal emitted is substantially not influenced by temperature variations, thus ensuring reliable and constant performances over a wide temperature range and over a wide frequency spectrum.

SUMMARY OF THE INVENTION

In general, the present invention is based on the consideration that, in an amplifying circuit, a stable output signal over a wide temperature range, i.e., an output signal which is substantially not influenced by the temperature variations can be obtained by inserting in one or more positions of the amplifying chain a compensated attenuator operating at radio frequency. In other words, the present invention is based on the consideration that a stable output signal may be obtained by inserting in the amplifying chain one or more temperature depending components performing a signal attenuation which varies as a function of the temperature. Such a component does not need to be controlled by control components for the purpose of modifying its attenuating function but its attenuating function varies automatically as a function of the temperature, that is the attenuating function is directly influenced by the temperature at which the component operates. In particular, by selecting a component wherein the signal crossing the component is attenuated less when the temperature increases and more when the temperature decreases, the signal gain variation due to temperature changes can be adequately compensated. In fact, when the signal gain decreases with increasing temperature the signal attenuation of such a component also automatically decreases. On the contrary, when the signal gain increase due to decreasing temperature, the signal attenuation performed also increases.

In other words, an increasing temperature corresponds to a decreased attenuation performed by the attenuator so that stronger signals enter the amplifying stages; accordingly, even if the signal is amplified less due to the increased temperature, substantially the same signal is obtained at the output terminal of the amplifying chain over a wide temperature range. In the same way, since the attenuation performed by the attenuating component automatically increases as the temperature decreases, weaker signals enter the amplifying stages at low temperature than at high temperature. Accordingly, weaker signals are amplified at the amplifying stages, thus compensating the signal gain increase arising when the temperature decreases.

As stated above, the temperature depending component according to the present invention is not a component wherein the attenuating function is driven by other components of the circuit in response to data collected by data collecting devices (temperature, signal gain and so on) but is a component wherein the attenuating performance automatically changes as the temperature changes. Therefore, according to the present invention, there is no need to insert into the amplifying circuit driving and/or data detecting devices, for the purpose of compensating the signal gain variation, but the signal gain variation is automatically compensated due to the fact that the attenuating performance automatically changes with the temperature. Accordingly, a stable amplified output signal is obtained at the output terminal of the amplifying circuit without any need of inserting in the circuit such driving and/or detecting devices as are normally used in the prior art amplifying circuits.

According to one embodiment, the present invention relates to a temperature compensated amplifying circuit having an uncompensated signal gain which varies as a function of the temperature. Said circuit comprises at least one amplifying stage having a signal input and at least one attenuating stage having a signal input and a signal output, with said attenuating stage being placed upstream with respect to the amplifying stage. The attenuating stage comprises a temperature depending component performing a signal attenuation which varies as a function of the temperature so as to compensate the uncompensated temperature depending signal gain, thus keeping the output signal of the circuit within a predefined range over a preselected temperature range.

According to a preferred embodiment, the amplifying circuit according to the present invention comprises a plurality of amplifying stages; in this way, it is possible to keep stable the signal gain of complex structure with a simple component.

According to another preferred embodiment, the amplifying circuit of the present invention comprises a IF section and a RF section, with each of said sections comprising at least an amplifying stage and an attenuating stage. This solution allows to stabilize the signal gain section by section and not only the overall signal gain.

According to a still preferred embodiment of the present invention, the attenuating stage comprises an element having an impedance with a negative temperature coefficient (NTC). In this way, the desired attenuation vs. temperature can be obtained.

According to a further preferred embodiment, said element having a impedance is a resistive element.

According to another preferred embodiment, the amplifying stage may comprise a resistive element connected in parallel with said element having a negative temperature coefficient. This solution may be preferred to balance the temperature depending characteristic of the NTC without negatively affecting the impedance matching.

BRIEF DESCRIPTION OF THE DRAWINGS

Further advantages, objects and features as well as embodiments of the present invention are defined in the appending claims and will become more apparent with the following detailed description when taken with reference to the accompanying drawings in which identical or corresponding parts are identified by the same reference numerals. In the drawings:

Figure 1 represents a typical prior art amplifying circuit comprising a monolithic attenuator;

Figure 2 represents a typical prior art amplifying circuit comprising an AGC feedback loop;

Figure 3 represents another typical prior art amplifying circuit comprising an AGC feedback loop based on a micro controller;

Figure 4 represents a further prior art amplifying circuit comprising a signal attenuator driven by a driving device operating in response to temperature values collected by a temperature sensor;

In Figure 5, there is depicted the signal gain behavior in a uncompensated prior art amplifying circuit;

Figure 6, represents a first embodiment of an amplifying circuit according to the present invention;

Figure 7, relates to a first embodiment of a temperature depending signal attenuator according to the present invention;

Figure 8 relates to a further embodiment of a temperature depending signal attenuator according to the present invention;

In Figure 9 there is depicted the typical signal gain behavior obtained in an amplifying circuit according to the present invention.

DETAILED DESCRIPTION OF THE INVENTION

While the present invention is described with reference to the embodiments as illustrated in the following detailed description as well as in the drawings, it should be understood that the following detailed description, as well as the drawings, are not intended to limit the present invention to the particularly illustrative embodiments disclosed, but rather that the described illustrative embodiments merely exemplify varies aspects of the present invention, the scope of which is defined by the appending claims.

The present invention is understood to be of particular advantage when used for RF transmission. For this reason, examples will be given in the following in which corresponding embodiments of the present invention relate to radio frequency amplifying circuits. However, it has to be noted that the present invention is not limited to RF amplifying circuits but can be used in any other situation in which it is required to compensate the signal gain variation arising from a changing temperature. The present invention is therefore also usable in all these applications, and the RF amplifying circuit described in the following illustrative embodiments are to represent any amplifying circuit, irrespective of the signal amplified and the operation frequencies.

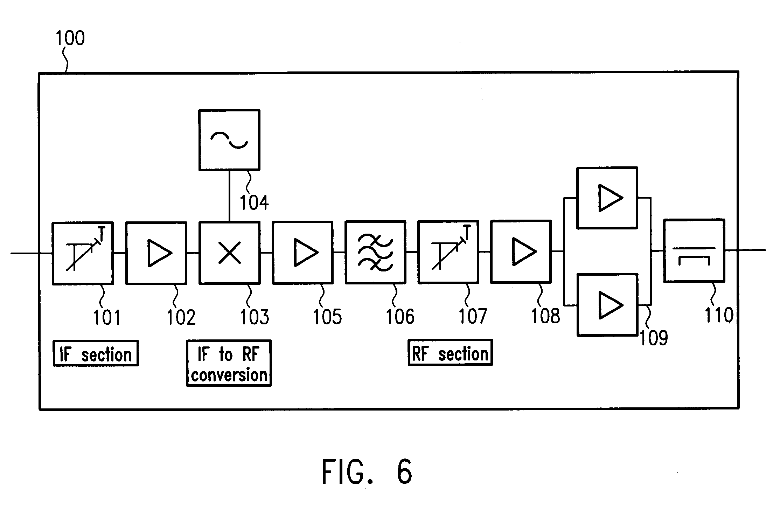

The present invention will now be described with reference to Figures 6 to 9.

In Figure 6, reference 100 relates to an amplifying chain (or a multi-stage amplifying system) of the kind to be used in a RF circuit. Said amplifying chain 100 (in the following also referred to as an amplifier) comprises a IF (intermediate frequency) section, an IF to RF (intermediate frequency to radio frequency) conversion section and a RF (radio frequency) section. The conversion section comprises a mixer 103 and an oscillator 104 connected therewith for converting the IF signal output by the IF section into a RF signal which is then processed in the RF section. The amplifying chain 100 further comprises three amplifying stages 102, 105 and 108 and a final amplifier stage 109. An output coupler 110 is connected to the final amplifier 9. The IF section comprises a first compensated attenuator 101 and a first amplifying stage 102. The first amplifying stage 102 is placed between the compensated attenuator 101 and the mixer 103 to increase the IF signal to a suitable level and to isolate the mixer input from the rest of the IF circuit.

The RF section comprises a second amplifying stage 105, a bandpass filter 106, a second compensated attenuator 107, a third amplifying stage 108 and a final amplifying stage 109. In the amplifying chain 100, the stages 101, 102, 103 and 105 to 110 are connected in series.

The amplifying stages 102, 105 and 108 have a behavior which is influenced by the temperature, that is, when one or both of the ambient temperatures and the temperature of the stage changes, the signal gain provided at each amplifying stage also varies as a function of the temperature. Accordingly, there is a need to compensate this signal gain variation for the purpose of obtaining a stable signal at the output terminal of the output coupler 110. In other words, the value of the output signal needs to be kept within a tight tolerance over a predefined temperature range and over a predefined frequency spectrum. To this end, the signal chain according to the embodiment of the present invention depicted in Figure 6 comprises the two temperature compensated attenuators 101 and 107 placed close to the amplifying stages 102 and 108, respectively. In particular, the output of the attenuator 101 is connected to the input of the amplifying stage 102 and the output of the attenuator 107 is connected to the input of the amplifying stage 108. The first temperature compensated attenuator 101 is provided for the purpose of stabilizing the power level of the IF signal entering into the mixer 103. In other words, the signal gain variation of the amplifying stage 102, as well as the gain variation due to the circuit before the attenuator 101 (not depicted in Figure 6) is compensated by attenuating the signal at the attenuator 101 as a function of the temperature. In particular, since it has been observed that the signal gain at an amplifying stage usually decreases as the temperature increases, an attenuator 101 is selected, wherein the attenuating function and/or performance decreases as the temperature increases and increases as the temperature decreases. It has to be noted, that the attenuator 101 is not driven by driving devices but is an attenuator wherein the attenuating performance automatically changes as the temperature changes, without any need for the attenuator 101 to be driven by external driving devices and/or means. In other words, the behavior of the attenuator 101 as a function of the temperature approximately inversely corresponds to the behavior of the amplifying stage 102 as a function of the temperature. By increasing temperature the signal gain at the amplifying stage 102 decreases, that is, weaker signals are emitted by the amplifying stage at high temperatures while stronger signals are emitted by the amplifying stage 102 at low temperatures. However, by increasing temperature, the attenuation at the attenuator 101 decreases whilst as the temperature decreases, the attenuation performed at the attenuator 101 increases; that is less attenuated signals are emitted by the attenuator 101 at high temperatures and more attenuated signals are emitted by the attenuator 101 at low temperatures. The fact that the attenuating function at the attenuator 101 changes as a function of the temperature in a manner approximately inversely corresponding to the manner in which the signal gain at the amplifying stage 102 changes, allows to compensate the signal gain variation at the amplifying stage 102. Accordingly, a substantially constant and/or stable signal is emitted by the IF section or at least the signals emitted by the IF section are kept within a predefined narrow range over a predefined temperature range.

The IF signal is then supplied to the RF section by means of the oscillator 104 and the mixer 103. Once the IF signal has been converted into a RF signal at the conversion section, the converted RF signal to be amplified enters the second amplifying stage 105 and subsequently enters the bandpass filter 106 to reject the image band and the residual OL.. Downstream with respect to the bandpass filter 106 there are provided a second temperature compensated attenuator 107 and a third amplifying stage 108. The second temperature compensated attenuator 107 is provided for the purpose of stabilizing the output power of the RF section by compensating the signal gain variation at the amplifying stages 105, 108 and 109 as a function of the temperature. The temperature compensated attenuator 107 is similar to the temperature compensated attenuator 101 and the way in which the RF signal emitted by the RF section is stabilized substantially corresponds to the way in which the IF signal is stabilized at the IF section. That is, the attenuating function of the attenuator 107 varies automatically as a function of the temperature in a manner which substantial inversely corresponds to the way in which the signal gain at the amplifying stage 108 varies as a function of the temperature. In this way, the signal gain variation at the amplifying stage 108 is compensated over a wide predefined temperature range and the values of the RF signals emitted by the RF section are kept within a predefined range over said predefined temperature range.

It has been observed that providing two temperature compensated attenuators, the first in the IF section and the second in the RF section, respectively, allows to compensate the signal gain variation of both the IF and RF section of the conversion/amplifier chain 100. The values of the signals entering into the attenuators 101 and 107 should lie between -5 and +20dBm. These values allow to maintain a good noise figure and to avoid excessive self heating of the attenuators 101 and 107.

The amplified RF signal emitted by the RF section enters the final amplifying stage 109 and is subsequently sent to the output coupler 110 from which it is finally outputted.

In the amplifying chain as depicted in Figure 6 the output power level is tightly controlled over a predefined wide temperature range; moreover, the IF section temperature compensation allows to supply a constant input IF level to the mixer maintaining the ideal operating condition for the mixer (optimal conversion performances) over a wide temperature range.

The advantage of the amplifying chain depicted in Figure 6 with respect to similar prior art amplifying chains is that the temperature compensated attenuators 101 and 107 inherently change the attenuating performance as a function of the temperature.

That is to say, the attenuators 101 and 107 do not need to be driven by external driving devices nor are additional devices needed for collecting data within the amplifying chain (signal gain, voltage, current, temperature etc) so as to drive the attenuators according to the data collected.

This is a very important difference of the amplifying chain of Figure 6 with respect to similar prior art amplifying chains. The attenuators 101 and 107 of the amplifying chain 100 of Figure 6 do not change their attenuating function in response to a driving signal emitted by a driving means but rather the attenuating performance of the attenuators 101 and 107 inherently and/or automatically varies as a function of the temperature. That is, automatically changing the attenuating performance is an intrinsic characteristic of the attenuators 101 and 107. Moreover, the inherent temperature dependence of the attenuator substantially inversely matches that of the uncompensated amplifying chain. Accordingly, since the signal gain variation as a function of the temperature can be known in advance, said signal gain variation can be adequately compensated by selecting attenuators having a predefined temperature depending attenuating behavior substantially inversely corresponding to the temperature depending signal gain behavior so that a substantial stable signal may be obtained.

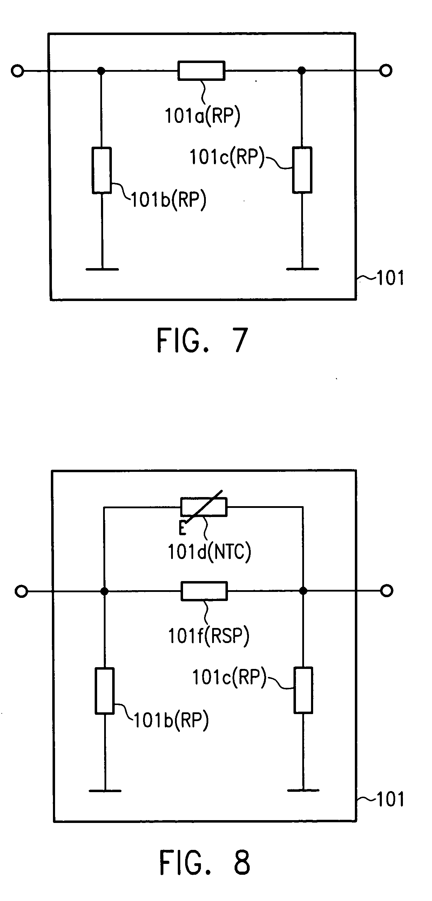

In the following the structure of the temperature compensated attenuators 101 and 107 of the amplifying chain 100 of Figure 6 will be described with respect to Figures 7 and 8. For a reason of clarity the description will be given of the attenuator 101 only. However, it has to be noted that the following description also applies to the attenuator 107.

In Figure 7, reference 101a relates to a first temperature depending resistor, in particular a resistor having a negative temperature coefficient. That is, the resistance of the resistor 101a decreases as the temperature increases. References 101b and 101c relate to further temperature depending resistors, namely resistors having a resistance which varies as a function of the temperature. However, the resistors 101b and 101c differ from the resistor 101a in that the way the resistance varies as a function of the temperature substantially inversely correspond to the way the resistance of the resistors 101a varies as a function of the temperature. That is, the resistance of the resistors 101b increases as the temperature increases. In other words, the resistors 101b and 101c have a positive temperature coefficient.

The resistor 101a is serially connected in an amplifying chain, for instance the amplifying chain 30 of Figure 6. The resistor 101b is adapted to be connected between two input terminals of the temperature compensated attenuator 101. In the particular case depicted in Figure 7 the resistor 101b is adapted to be connected between an input terminal of the attenuator 101 and the ground. However, other solutions are possible, for instance the resistor 101b could be connected between the input terminal of the attenuator 101 and another terminal connected to a reference potential to which the input signal is related. In other embodiments the resistor 101b may be connected between differential input terminals of the attenuator 101. The temperature depending resistor 101c is adapted to be connected between two output terminals of the temperature compensated attenuator 101. In Figure 7, the temperature depending resistor 101c is connected between the output terminal of the attenuator 101 and the ground. However, in the same way as the temperature depending resistor 101b, the temperature depending resistor 101c could be connected between the output terminal of the attenuator 101 and a second output terminal connected to the reference potential or between differential output terminals. In other embodiments, the resistors 101b and 101c may be provided as "adaptive" elements to adapt the attenuator input and/or output to any preceding or subsequent stage in high frequency applications. To this end, the temperature related variation of one or both of the resistors 101b and 101c may be significantly less than that of the resistor 101a so that the adaptation is substantially independent from the temperature.

Inserting one or more of the attenuators 101 depicted in Figure 7 in an amplifying chain of the kind represented in Figure 6 allows to compensate the signal gain variation which would arise as a function of the temperature. The reason for that can be explained as follows.

Each resistor has a resistance which varies as a function of the temperature according approximately to the following rule:

$$(1) \qquad R = R_0 \, \exp(\beta(1/T - 1/T_0)$$

where $\beta$ is the exponential temperature coefficient of the resistor, T is the temperature of the resistor, $T_0$ is the temperature of reference and $R_0$ is the resistance of the resistor at the temperature $T_0$.

Whilst in the conventional resistors the parameter $\beta$ substantially corresponds to zero, the temperature depending resistors are characterized in that they have a parameter $\beta$ which is less than zero. In particular, resistors with a negative temperature coefficient (NTC resistors) have an high, positive $\beta$ coefficient. Accordingly, NTC resistors are characterized in that their resistance R exponentially decreases when the temperature increases. On the contrary, positive temperature coefficient resistors (PTC resistors) have a resistance that exponentially increases as the temperature increases.

In Figure 5, a logarithmic scale (dB) has been used for representing the relationship between the signal gain and the temperature in the case of a common amplifying device, for instance one of the amplifying stages of Figure 6 or a combination thereof.

As apparent from Figure 5, when a logarithmic scale is used, the signal gain appears to vary substantially linearly as a function of the temperature. However, if a natural scale would be used, it would be evident that the signal gain varies as a function of the temperature according to a function which is substantially exponential.

Thus, the way the signal gain varies as a function of the temperature, substantially corresponds to the way the resistance of a NTC resistor varies as a function of the temperature. That means, in a temperature compensated attenuator equipped with an NTC resistor and one or more PTC resistors opportunely mutually connected, (for instance, the attenuator 101 of Figure 7) the attenuating performance varies in a way which substantially inversely corresponds to the way the signal gain varies as a function of the temperature.

Accordingly, if a device as depicted in Figure 7, is used in an amplifying chain of the kind depicted in Figure 6 (by placing the attenuating device close to a preselected amplifying stage) the signal attenuation at the attenuating device would compensate the signal gain variation at the amplifying stage and a substantially constant output signal would be obtained. In fact, in the attenuating stage 101 depicted in Figure 7, the signal output by the device 101 of Figure 7 varies as a function of the temperature. In particular, for a constant input signal and for an increasing temperature the signal emitted is higher compared to the output signal for a decreasing temperature. It results therefore, that inserting the temperature depending attenuating device 101 of Figure 7 in an amplifying chain, in particular by connecting the device 101 upstream with respect to an amplifying stage, would result in less attenuated signals entering the amplifying stage at low temperatures whilst more attenuated signals would enter the amplifying stage at high temperatures. Since the signal gain at the attenuating stage also varies as a function of the temperature (the signal gain decreases by increasing temperature and increases by decreasing temperature) the temperature depending attenuating function of the attenuating device 101 of Figure 7 would compensate the temperature depending signal gain variation at the amplifying stage and a substantially constant signal would be emitted by the amplifying stage or at least the signals emitted would be kept within a narrow range over a predefined temperature range.

One or more attenuating devices as depicted in Figure 7 may be inserted in an amplifying chain. In particular, it has been observed that inserting two attenuating devices by connecting each of them upstream with respect to corresponding amplifying stages allows to stabilize the signal gain of the all amplifying chain.

According to another embodiment the PTC resistors 101b and 101c of Figure 7 may be substituted by fixed resistors i.e., resistors the resistance of which is substantially significantly less dependent on the temperature. This allows to simplify the circuit of Figure 7, thus rendering it less expensive and more usable for different applications.

The temperature depending resistor 101a may be one of the largely known NTC SMD (surface mount device) resistors.

In Figure 8 there is depicted an alternative embodiment of the temperature depending attenuating device 101 of Figure 7.

In Figure 8, the resistor 101a of Figure 7 has been substituted by two resistors, in particular an NTC resistor 101d and a resistor 101f, connected in parallel. The resistor 101f is adapted to be serially connected in an amplifying chain in the same way as described with respect to the resistor 101a of Figure 7. The resistor 101f may be either a temperature depending resistor or a resistor the resistance of which does not substantially vary as a function of the temperature. The function of the resistor 101f is that of balancing the function of the NTC resistor 101d so as to obtain a predefined behavior for the two resistors 101d and 101f as a function of the temperature. Two resistors are further provided, namely a resistor 101b and a resistor 101c. As apparent from Figure 8, the resistor 101b is adapted to be connected between two input terminals of the device 101 whilst the resistor 101c is adapted to be connected between two output terminals of the device 101 in the same way as described with respect to the temperature depending attenuating device of Figure 7. The resistors 101b and 101c may be either temperature depending resistors (PTC resistors) or resistors exhibiting a substantially constant resistance over a predefined temperature range. The embodiment wherein the resistors 101b, 101c and 101f are provided as SMD fixed resistors and the resistor 101d is provided as NTC resistor (always in SMD technology) may be preferred in some circumstances for the following reason.

Firstly, this embodiment provides substantially the same performances as the embodiment wherein the resistors 101b and 101c are provided as PTC resistors. Moreover, it is possible to obtain every reasonable configuration of values of A (attenuation) and $\Delta A/\Delta T$ always maintaining the same NTC component (type and value) while only changing the very low cost SMD fixed resistors. It is well known that changing the value of an SMD resistor is a simple and cheap operation; moreover, SMD fixed resistors of almost every value are at large disposal, exhibiting a good quality and reliability and at a low price.

The embodiment comprising three fixed resistors 101b, 101c and 101f is therefore able to support a wide family of temperature compensated attenuators, with a wide range of A and $\Delta A/\Delta T$ values, by simply changing the values of the SMD fixed resistors. This represents a very important advantage of this embodiment.

Moreover, it is also possible to achieve a good impedance matching at the input and the output of the circuit.

Also the attenuating device of Figure 8 is preferably connected upstream with respect to an amplifying stage of the amplifying chain. Moreover, using two attenuating devices allows to compensate the signal gain variation of the all amplifying chain. When more than one attenuating device is used, each of said attenuating devices is connected upstream with respect to a corresponding amplifying stage.

The design of the devices 101 of Figure 7 and 8 can be carried out as a function of the signal gain variation of the amplifying chain in which said attenuating devices have to be inserted. In particular, the uncompensated signal gain variation may be analyzed as a function of the temperature and the parameters of the resistors of the attenuating devices (NTC resistors, PTC resistors, constant resistors etc) may be defined accordingly.

Usually, the value of the NTC component usable for realizing temperature compensated attenuating devices may be varied between 100 and 220 Ohm at a temperature of approximately 25°C: The coefficient $\beta$ is usually approximately 3000. When these values are selected it is possible to obtain a good impedance matching over a temperature range of about 70°, with a signal gain variation which is not more than 0.5dB/1 0°.

In the following table there is depicted an example of the way the parameters of the components of the temperature depending attenuating device of Figure 8 may be selected for the purpose of compensating the signal gain variation of an amplifying chain.

| Temp (°C) | Rp ($\Omega$) | Rsp ($\Omega$) | Rs ($\Omega$) | Rpar ($\Omega$) | I.R.L. (dB) | I.L. (dB) | $\Delta$G/$\Delta$T (dB) |
|---|---|---|---|---|---|---|---|
| 0 | 270 | 42 | 31.28 | 42.19 | -22.92 | -4.81 | |
| 10 | 270 | 42 | 27.93 | 42.19 | -25.42 | -4.41 | 0.39 |
| 20 | 270 | 42 | 24.52 | 42.19 | -29.43 | -3.98 | 0.43 |
| 30 | 270 | 42 | 21.15 | 42.19 | -37.78 | -3.53 | 0.45 |
| 40 | 270 | 42 | 17.99 | 42.19 | -42.01 | -3.09 | 0.44 |
| 50 | 270 | 42 | 15.14 | 42.19 | -31.1 | -2.66 | 0.42 |
| 60 | 270 | 42 | 12.66 | 42.19 | -26.71 | -2.28 | 0.38 |
| 70 | 270 | 42 | 10.54 | 42.19 | -24.09 | -1.94 | 0.34 |

In the above table $R_p$ is the value of the resistors 101b and 101c; $R_{sp}$ is the value of the resistor 101f that is connected in parallel with the NTC resistor 101d. $R_s$ is the resistance value of the combination of the resistors 101f and 101d (this resistance value varies as a function of the temperature); $R_{par}$ is the resistance value of a combination of the resistance 101b or 101c and a 50$\Omega$ resistance, when connected in parallel (standard intrinsic impedance); I.R. L defines the input return loss i.e., a measure of the input matching of the circuit; I.L. means insertion loss, i.e., a measure of the power attenuation introduced by the circuit.

From the above table it is apparent that a predefined compensation of the signal gain variation may be obtained by opportunely selecting the parameters of the resistors of the temperature depending attenuating device by maintaining at the same time a very good impedance matching and with a very limited insertion loss. For elevated values of $\Delta$G/$\Delta$T it is preferred to use a cascade connection of at least two attenuating devices.

The results obtained in an amplifying chain equipped with the device of either Figure 7 or Figure 8 are summarized in Figure 9. In particular, in Figure 9, there are depicted the results obtained in the case of the attenuating chain of Figure 6.

As apparent from Figure 9, the signal gain variation is kept within a range of 0.4dB over a temperature range of about 70°. This has to be compared with the signal gain variation depicted in Figure 5, namely a signal gain variation of approximately 3dB over the same temperature range.

It results therefore that without attenuating the signal as a function of the temperature it is not possible to obtain a stable output signal, even over a limited temperature range. On the contrary, by using two temperatures depending attenuating devices of the kind depicted in Figure 7 or 8, with each of said attenuating devices being inserted upstream in the amplifying chain with respect to the corresponding amplifying stages, a stable output signal is obtained with good impedance matching and without negatively effecting the noise figure or the amplifying chain.

The temperature depending attenuating device according to the present invention has revealed to be advantageous in different applications and for different purposes. In fact, when different attenuating performances are required, it suffices to substitute the constant resistors 101b and 101c, whilst the NTC resistor may be maintained. The parameter of the temperature depending attenuating device of the present invention may also be easily selected as a function of the results to be achieved. The design of the temperature depending device of the present invention results therefore to be extremely simplified.

As stated above, the temperature depending attenuating device according to the present invention allows to obtain very good compensation of the signal gain variation without figuratively affecting the noise figure of the chain in which it is inserted and maintaining at the same time a very good impedance matching. For instance, it has been observed that circuit in a exhibiting an uncompensated variation gain of $\pm1.5$dB over a range of temperatures from 0° to approximately 70° the signal gain variation may be compensated so as to be contained within a range of $\pm0.2$dB over the same temperature range. When a temperature compensated attenuating device according to the present invention is used in an amplifying chain the input impedance matching may be efficiently controlled and the insertion loss may also be adequately contained. The temperature depending attenuating device of the present invention may also be used in those applications where the frequency spectrum extends beyond 3 GHz. Moreover, the inventive temperature depending attenuating devices have a low cost and may easily be adapted to different applications.

**Claims**

1.   A temperature compensated amplifying circuit (100) having an uncompensated signal gain which varies as a function of the temperature, said circuit comprising:

   at least one amplifying stage (102, 105, 108) having a signal input;

   at least one attenuating stage (101, 107) having a signal input and a signal output, with said attenuating stage (101, 107) being placed upstream with respect to the amplifying stage;

   **characterized in that**
   said attenuating stage (101, 107) comprises a temperature depending component (101a, 101b, 101c, 101d, 101f) performing a signal attenuation which varies as a function of the temperature so as to compensate the uncompensated temperature depending signal gain, thus keeping the output signal of the circuit within a predefined range over a preselected temperature range.

2.   A circuit as claimed in claim 1, comprising a plurality of amplifying stages (101, 107).

3.   A circuit as claimed in one of claims 1 and 2, said circuit being adapted to amplifying a RF signal.

4.   A circuit as claimed one of claims 1 to 3, said circuit comprising a IF section and RF section, with each of said sections comprising at least an amplifying stage and an attenuating stage.

5.   A circuit as claimed in claim 4, said circuit further comprising an oscillator (104) between the IF section and the RF section, with said oscillator being adapted to convert the IF signal into a RF signal.

6.   A circuit as claimed in one of claims 1 to 5, wherein said at least one amplifying stage (101, 107) comprises an element (101d) having an impedance with a negative temperature coefficient.

7.   A circuit as claimed in claim 6, wherein said element (101d) having an impedance is a resistive element.

8.   A circuit as claimed in one of claims 6 and 7, wherein said at least one amplifying stage (101, 107) further comprises a resistive element (101f) connected in parallel with said element (101d) having a negative temperature coefficient.

9.   A circuit as claimed in one of claims 6 to 8, wherein said at least one amplifying stage (101, 107) further comprises an input resistive element (101b) connected between two input terminals of said signal input.

10.   A circuit as claimed in one of claims 6 to 9, wherein said at least one amplifying stage (101, 107) further comprises an output resistive element (101c) connected between two output terminals of said signal output.

11.   A circuit as claimed in one of claims 9 to 10, wherein said input resistive element (101b) has a positive temperature coefficient that substantially inversely corresponds to said negative temperature coefficient of said element having an impedance.

12.   A circuit as claimed in one of claims 9 to 11, wherein said output resistive element (101c) has a positive temperature coefficient that substantially inversely corresponds to said negative temperature coefficient of said element (101d) having an impedance.

**13.** A circuit as claimed in one of claims 1 to 12, wherein the signal gain of the circuit is kept within a range of substantially 6dB over a temperature range of 50°C.

**14.** A circuit as claimed in claim 13, wherein the signal gain is kept within a range of substantially 3dB over a temperature range of approximately 70°C.

**15.** A circuit as claimed in one of claims 14 to 15, wherein the signal gain is kept within said ranges over a frequency range from approximately 200 MHz to 1200MHz.

FIG. 1
(Prior Art)

FIG. 2
(Prior Art)

30

31    32    33    34

36

37

39

Pin
Measure

Control Signal
Source
D/A converter

Temperature
sensor

Pout
Measure

Microcontroller

35

38

FIG. 3
(Prior Art)

40

41    42    43

45

Control Signal

T
sense

44

46

FIG. 4
(Prior Art)

FIG. 5

FIG. 9

EP 1 432 121 A1

100

104

101    102    103    105    106    107    108                109           110

IF section

IF to RF
conversion

RF section

FIG. 6

101a(RP)

101c(RP)

101b(RP)

~101

FIG. 7

E
101d(NTC)

101f(RSP)

101c(RP)

101b(RP)

~101

FIG. 8

## EUROPEAN SEARCH REPORT

**European Patent Office**

Application Number

EP 02 02 8195

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | PATENT ABSTRACTS OF JAPAN<br>vol. 2000, no. 04,<br>31 August 2000 (2000-08-31)<br>& JP 2000 031746 A (MITSUBISHI ELECTRIC CORP), 28 January 2000 (2000-01-28)<br>* abstract; figures 1-4,7 * | 1-3,6-15 | H03F1/30<br>H03G1/00<br>H01C13/00 |
| Y | | 4,5 | |
| X | PATENT ABSTRACTS OF JAPAN<br>vol. 2000, no. 10,<br>17 November 2000 (2000-11-17)<br>& JP 2000 196395 A (MITSUBISHI ELECTRIC CORP), 14 July 2000 (2000-07-14)<br>* abstract; figures 5,8,9,11 * | 1-3,6-8,<br>13-15 | |
| Y | | 4,5 | |
| X | PATENT ABSTRACTS OF JAPAN<br>vol. 1996, no. 09,<br>30 September 1996 (1996-09-30)<br>& JP 08 125451 A (KOKUSAI ELECTRIC CO LTD;KOKUSAI DENKI ENG:KK),<br>17 May 1996 (1996-05-17)<br>* abstract; figure 1 * | 1-3,6-15 | TECHNICAL FIELDS SEARCHED (Int.Cl.7)<br><br>H03F<br>H03G<br>H01C |
| Y | | 4,5 | |
| X | US 3 705 316 A (DEBOO GORDON J ET AL)<br>5 December 1972 (1972-12-05)<br>* column 3, line 4 - column 6, line 61; figures 3,4 * | 1,2,6-8 | |
| Y | US 2001/023190 A1 (KIM TAE YOUNG)<br>20 September 2001 (2001-09-20)<br>* abstract; figures 1,2 * | 4,5 | |

-/--

The present search report has been drawn up for all claims

| Place of search | Date of completion of the search | Examiner |
|---|---|---|
| MUNICH | 15 May 2003 | Dietsche, S |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

EP 1 432 121 A1

**European Patent Office**

**EUROPEAN SEARCH REPORT**

Application Number

EP 02 02 8195

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | PATENT ABSTRACTS OF JAPAN vol. 1997, no. 09, 30 September 1997 (1997-09-30) & JP 09 139646 A (TEKUDAIYA KK), 27 May 1997 (1997-05-27) * abstract; figures 1-9 * --- | 1-3,6,7, 9-12 | |
| A | PATENT ABSTRACTS OF JAPAN vol. 2002, no. 11, 6 November 2002 (2002-11-06) & JP 2002 208803 A (NEW JAPAN RADIO CO LTD), 26 July 2002 (2002-07-26) * abstract; figure 7B * ----- | 1 | |
| | | | TECHNICAL FIELDS SEARCHED (Int.Cl.7) |

The present search report has been drawn up for all claims

| Place of search | Date of completion of the search | Examiner |
|---|---|---|
| MUNICH | 15 May 2003 | Dietsche, S |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

18

## ANNEX TO THE EUROPEAN SEARCH REPORT
## ON EUROPEAN PATENT APPLICATION NO.

EP 02 02 8195

This annex lists the patent family members relating to the patent documents cited in the above-mentioned European search report.
The members are as contained in the European Patent Office EDP file on
The European Patent Office is in no way liable for these particulars which are merely given for the purpose of information.

15-05-2003

| Patent document cited in search report | | Publication date | Patent family member(s) | | Publication date |
|---|---|---|---|---|---|
| JP 2000031746 | A | 28-01-2000 | NONE | | |
| JP 2000196395 | A | 14-07-2000 | NONE | | |
| JP 08125451 5 | A | | NONE | | |
| US 3705316 | A | 05-12-1972 | NONE | | |
| US 2001023190 | A1 | 20-09-2001 | KR CN | 2001091576 A 1314766 A | 23-10-2001 26-09-2001 |
| JP 09139646 5 | A | | NONE | | |
| JP 2002208803 | A | 26-07-2002 | NONE | | |

EPO FORM P0459

For more details about this annex : see Official Journal of the European Patent Office, No. 12/82